# EUROPEAN PATENT SPECIFICATION

(11) **EP 2 597 674 B1**
(45) Date of publication and mention of the grant of the patent: **29.03.2017**
(21) Application number: 13156047.6
(22) Date of filing: 08.11.2010
(51) Int. Cl.: H01L 27/115, H01L 21/28, H01L 29/423, H01L 29/49

(54) **Method for producing a floating gate memory structure**
Verfahren zur Herstellung einer Speicherstruktur mit Freischwebegate
Procédé de production d'une structure de mémoire à grille flottante

(43) Date of publication of application: 29.05.2013
(62) Divisional of application: 10190373.0
(73) Proprietor: IMEC, 3001 Leuven (BE)
(72) Inventor: Loo, Roger, B-3010 KESSEL-LO (BE); Caymax, Matty, B-3001 LEUVEN (BE); Blomme, Pieter, B-8400 OOSTENDE (BE); Van Den Bosch, Geert, B-3010 LEUVEN (BE)
(74) Representative: Pronovem

(56) References cited:
- US-A- 6 159 801
- US-A1- 2005 142 725
- US-A1- 2009 001 425
- US-A1- 2010 052 035
- US-A1- 2010 187 594

## Description

### Field of the Invention

The present invention is related to the production of semiconductor devices, in particular of floating gate memory devices.

### State of the art.

Though various types of floating gate nonvolatile memory devices exist, they all have in common the need to obtain a thin tunnel oxide layer on a semiconductor substrate, mostly a silicon substrate. Document US2003/0011018 for example describes a method wherein openings are made in the tunnel oxide layer and wherein monocrystalline silicon is epitaxially grown over the tunnel oxide with the openings serving as seed areas for the epi-growth. This is an example of so-called Selective Epitaxial Growth (SEG) of silicon during which the nucleation of polycrystalline Si on top of e.g. silicon nitride/oxide layers is prevented. The monocrystalline material will form the actual floating gate in the finished device.

It is important to clean the seed areas and to remove the native oxide before the epi-growth can start. This conventional cleaning process usually comprises a wet chemical clean having a last step treatment with aqueous solutions containing hydrogen fluoride, a so-called 'HF dip'. This step causes uncontrolled thinning of said tunnel oxide leading to reproducibility issues, and possibly appearance of areas of non-uniform tunnel oxide thickness.

In flash memory devices, it is known to produce arrays of columnar floating gate structures produced from polysilicon, and having a certain thickness between parallel sidewalls. The ONO (oxide-nitride-oxide) interpoly dielectric runs along the sidewalls of the floating gate in order to provide a large capacitance between floating gate and control gate and therefore a large coupling ratio.

In order to scale the cell, it is necessary to reduce one or more of the length of the floating gate, the length of the control gate and the thickness of the interpoly dielectric. For scaled devices the length of the structures are becoming smaller and smaller and the pattern more dense. The limit of scaling would be given by a half pitch which is filled by the interpoly dielectric (on both sides). This implies that the pitch of floating gates (defined as the sum of the floating gate length and the space between two adjacent floating gates) cannot be scaled below a value which corresponds to the sum of the floating gate (FG) length (scalable to about 5nm), the control gate (CG) length (scalable to about 5nm) and two times the ONO interpoly (IPD) thickness (scalable to about 15nm). This gives a total sum of about 40nm and therefore a limit of scaling of 20nm half pitch (i.e. half-pitch below 20nm is difficult to achieve). A solution for this is to make a thinner vertical inter-poly dielectric, but this is not trivial for the ONO (oxide-nitride-oxide) stacks in use.

US2010/0187594 A1 and US2010/0052035 A1 disclose floating gate memory devices having an array of columnar floating gate structures of monocrystalline semiconductor material and control gate structures. ¶

### Summary of the invention

The invention provides a solution to the problems mentioned above. It is related to methods and devices as described in the appended claims.

The invention is related to a method for producing a floating gate memory device with a columnar structure having an improved density compared to existing devices. The invention is related to a method for producing a floating gate memory device comprising the steps of :
- Providing a monocrystalline semiconductor substrate,
- Forming a tunnel oxide layer on said substrate,
- Producing one or more openings in said tunnel oxide, to expose areas of said semiconductor substrate,
- Cleaning the exposed substrate with a cleaning liquid,
- Loading the substrate into an epitaxial reactor, and thereafter :
- Optionally, annealing the substrate, to thereby remove any remaining oxides from the areas,
- Epitaxially growing a monocrystalline semiconductor layer on the substrate by selective epitaxial growth using the exposed substrate areas as source areas,
- Planarizing the monocrystalline semiconductor layer,
- Depositing a hard mask layer made of dielectric material on the planarized monocrystalline layer,
- Depositing and patterning a layer of resist on the hard mask layer,
- Etching the monocrystalline layer, stopping on the tunnel oxide layer, thereby forming columnar monocrystalline floating gate structures,
- Etching trenches between said columnar floating gate structures, through the portions of the tunnel oxide layer situated between the columnar floating gate structures,
- Filling said trenches with a dielectric material, leaving a portion of the columnar floating gate structures exposed,
- Thermally growing an oxide layer on each of the lateral sides of the columnar floating gate structures,
- Depositing a control gate layer between and on top of said columnar floating gate structures.

According to an embodiment of the method according to the invention, the method further comprises, after the step of forming a tunnel oxide layer, the step of depositing a protective layer on said tunnel oxide layer, thereby forming a stack of the tunnel oxide and the protective layer on the substrate, wherein said openings are produced in said stack, to expose said areas of the semiconductor substrate, and further comprising the step, after the steps of loading the substrate into an epitaxial reactor and optionally annealing the substrate and before the step of epitaxially growing a monocrystalline semiconductor layer, of removing the protective layer, by an in-situ etching process wherein the protective layer is etched selectively with respect to the tunnel oxide layer.

Preferably, the selectivity of the etching process for etching the protective layer versus etching the tunnel oxide layer is 100:1 or more.

According to an embodiment of the method according to the invention, said substrate is a monocrystalline Si substrate, and said tunnel oxide layer is a thermally grown layer of SiO₂ and said protective layer is an amorphous Si layer or a polycrystalline Si layer.

According to an embodiment of the invention, said cleaning liquid is hydrogen fluoride (HF), and said in-situ etching process is performed by exposing the substrate to a halogen containing precursor.

According to a preferred embodiment of the invention, the thickness of said thermally grown oxide layer on the lateral sides of said floating gate structures is between 5nm and 15nm, preferably between 5nm and 10nm, more preferably between 6nm and 8nm.

Furthermore according to the invention, the half pitch between adjacent columnar floating gate structures is between 10nm and 20nm, preferably between 10nm and 15nm, more preferably between 11nm and 13nm.

The invention is also related to a floating gate memory device, comprising at least one array of columnar floating gate structures of monocrystalline semiconductor material, with control gate structures in between said columnar structures, wherein each of said columnar structures is provided with an oxide layer on each lateral side plane of said columnar structures, to thereby isolate each floating gate structure from the neighbouring control gate structures, and wherein the thickness of said oxide layers is between 5nm and 15nm, preferably between 5nm and 10nm, more preferably between 6nm and 8nm and the half pitch of said array is between 10nm and 20nm, preferably between 10nm and 15nm, more preferably between 11nm and 13nm.

In a device according to the invention, said oxide layer on each lateral side plane is a thermally grown oxide layer. The device has a dielectric layer portion on top of said columnar floating gate structures. According to an embodiment, the thickness of said dielectric layer portion is higher than the thickness of said oxide layers on the lateral side planes of said columnar floating gate structures.

According to an embodiment of the device, said control gate structures are completely surrounding said columnar floating gate structures. Said control gate structures may be polysilicon structures.

According to an embodiment of the device, said columnar floating gate structures comprise a tunnel oxide layer of thermally grown oxide. The thickness of said thermally grown tunnel oxide layer may be between 5 and 10nm.

### Brief description of the figures

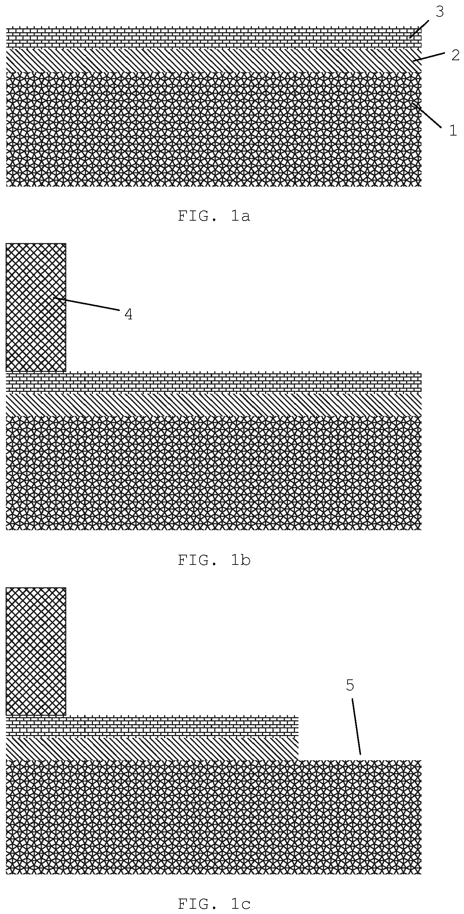

Figures 1a to 1m illustrate the process flow of the fabrication of a floating gate memory device according to the method of the invention.

### Detailed description of the invention

With reference to figures 1a to 1m, the method according to the invention is illustrated. The invention is not limited to the method shown in these drawings, but is applicable to the fabrication of any type of floating gate memory device.

The invention is characterized by the formation of the columnar floating gate structures provided with a thin thermally formed oxide layer on the lateral sides.

In a first step (fig. 1a), a monocrystalline silicon substrate 1 is provided, and a tunnel oxide layer 2 is produced onto said substrate. This is a thin layer of SiO₂ preferably obtained by thermal oxidation of the substrate. The tunnel oxide thickness is of the order of 5-10nm.

In an optional step, a protection layer 3 may then be deposited, for example by Chemical Vapour Deposition (CVD) onto the tunnel oxide layer 2. This protection layer can be a layer of amorphous Si. Alternatively, it can be a polycrystalline Si layer. If it is deposited, the thickness of this layer can be a few nm, in any case the thickness must be sufficient to cover the complete tunnel oxide layer, and to maintain said complete coverage during the subsequent wet chemical cleaning step.

Then stopping structures 4 are produced on the amorphous silicon layer (fig. 1b). These structures (only one shown) are configured to stop a chemical mechanical polishing operation (CMP). According to a preferred embodiment, these stopping structures are silicon nitride (Si₃N₄) stoppers obtained by depositing a layer of Si₃N₄ and then patterning said layer to define protrusions which act as CMP stoppers. Advantageously during the epitaxial growth silicon does not nucleate on the stoppers made of stoichiometric Si₃N₄.

Alternatively, and in the case when no protective layer is used, the stoppers may be produced directly onto the substrate 1, before production of the tunnel oxide layer 2 and (optionally) the protective layer 3, said layers being deposited conformally onto the substrate 1 and onto the stoppers 4.

Then openings are etched in the stack of tunnel oxide 2 and amorphous Si layer 3 (or in the tunnel oxide layer when no protective layer is used), by a known litho and dry etch process (fig. 1c) followed by a post-etch wet clean (strip) process, to thereby expose the Si-substrate in areas 5 (only one shown).

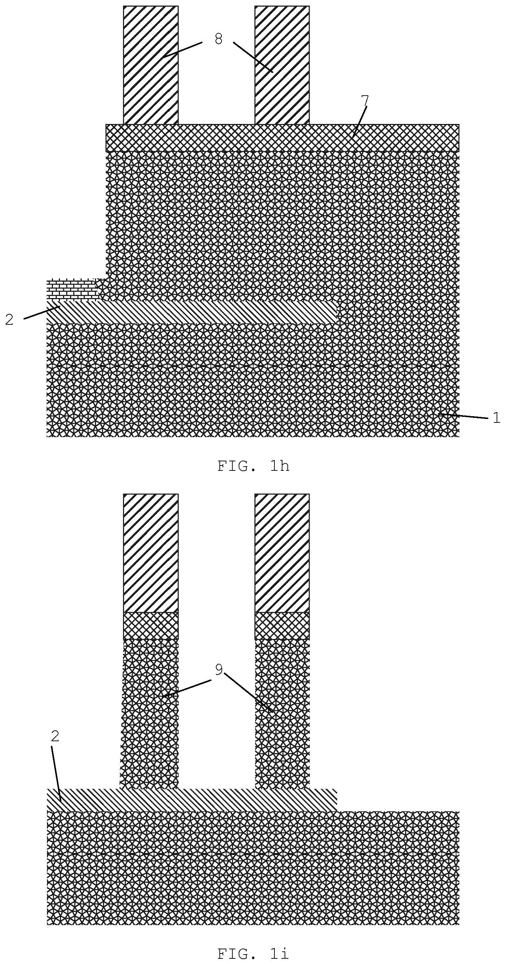

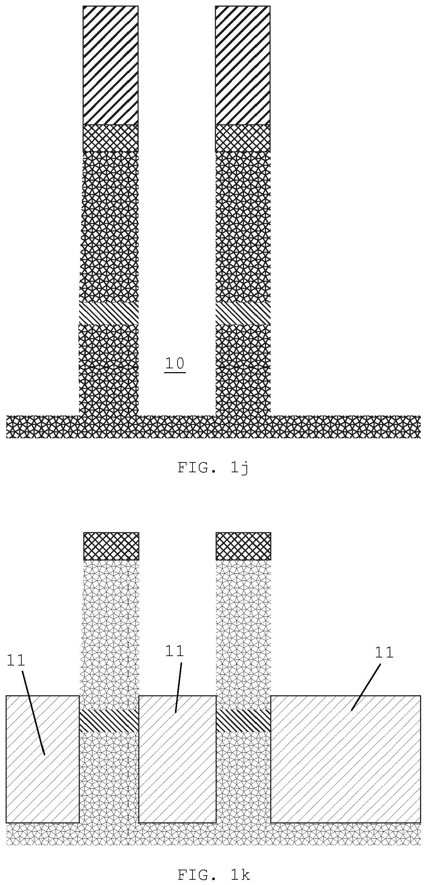

After litho, etch and post-etch strip, these areas 5 are covered by a native oxide layer, which is removed in the next process step by a wet chemical clean, preferably an HF dip. Advantageously, if present, the protective layer 3 protects the tunnel oxide layer during this HF dip, so that the tunnel oxide layer thickness remains unaltered in the area where the floating gate structures will be produced. It is possible that at the lateral sides of the areas 5, the tunnel oxide layer is slightly etched during the wet chemical cleaning step. However, at the future locations of the floating gate structures (see fig. 1i and 1j), the thickness of the tunnel oxide is maintained.

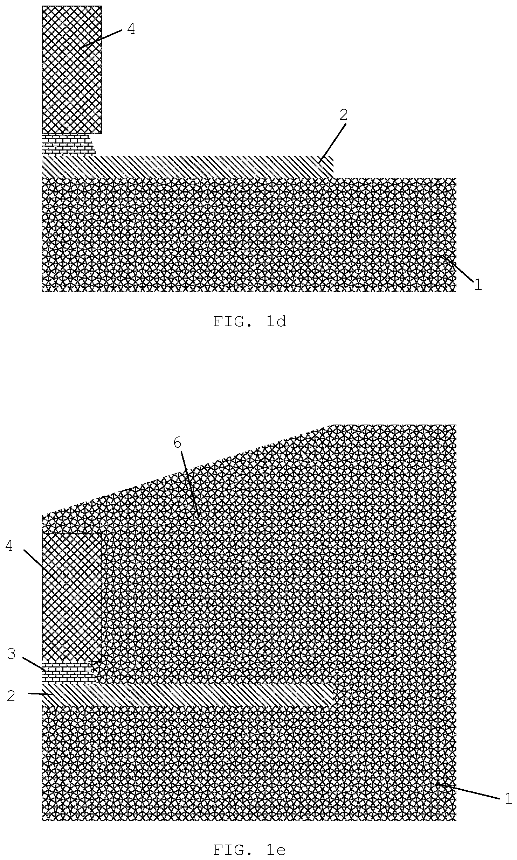

Then the substrate is preferably moved into the reactor for epitaxial Si-growth, where the next steps are performed in-situ. Possibly, a pre-epi baking step is performed at a temperature between 600°C and 1050°C, typically at 850°C. The primary aim of this pre-epi baking step is to remove any oxides from the areas 5 which may have been formed during transition from the wet-cleaning installation to the epi-reactor. If an amorphous Si layer is used as the protective layer, the amorphous silicon transforms into poly-silicon during the pre-epi baking step. If any type of protective layer is used, this protective layer is then removed selectively with respect to the underlying tunnel oxide by in-situ etching with HCl-containing precursors at a temperature between 600°C and 1000°C, preferably at about 850°C (fig. 1d). Alternatively, no pre-epi bake is done and the protective layer 3 is removed selectively with respect to the underlying tunnel oxide by the in-situ HCl treatment at the same temperature between 600°C and 1000°C, preferably at about 850°C. This step is not limited to a HCl etching step but could be done in the presence of other halogen-based precursors, e.g. Cl₂. Preferably, the selectivity of the etching process for etching the protective layer versus etching the tunnel oxide is 100:1 or more. The selectivity of the etching process for etching the protective layer versus monocrystalline silicon is less critical. It is preferably 10:1 or more, so that not more than a limited amount of monocrystalline Si is etched in the areas 5 during this step. However, even when more monocrystalline Si is etched (even when there is no selectivity), the result is satisfactory, given that an oxide-free surface of monocrystalline Si is obtained in the areas 5, on which further monocrystalline Si can be grown by SEG.

After this, the SEG step is done (fig. 1e), to form a laterally overgrowing monocrystalline Si-layer 6 starting from the areas 5, and extending over the tunnel oxide to a thickness above the height of the CMP-stoppers 4. Preferably, the CMP stoppers 4 are formed in between areas 5, so that two overgrowing epitaxial Si-layers, originating from two adjacent areas 5 come into mutual contact in the space above the CMP stop situated between the two areas 5. In this way, the border area between the two monocrystalline layers is at a safe distance from the substrate regions on either side of the stoppers. Such border areas are bound to contain irregularities in terms of the crystal structure.

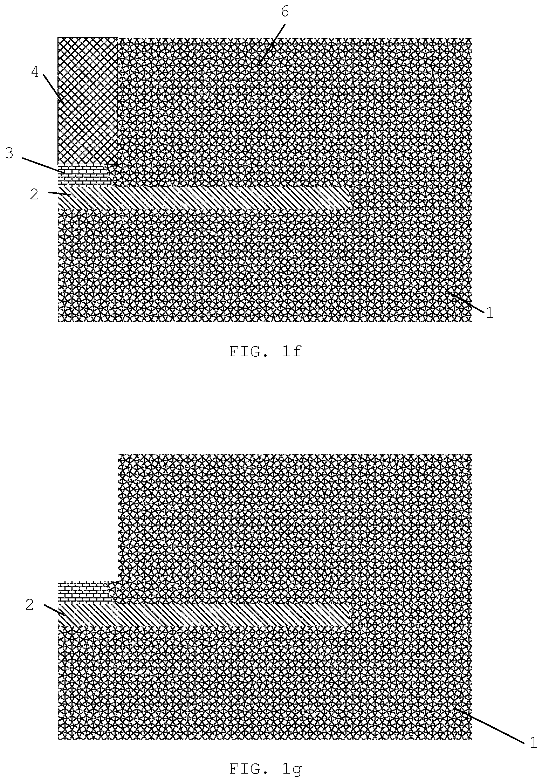

This is followed by a CMP step, to planarize the monocrystalline Si-layer (fig. 1f), and subsequently by the removal of the CMP stoppers, e.g. by a selective wet etch of the silicon nitride stoppers (fig. 1g)

By the further steps (figs 1h to 1m), columnar floating gate structures are produced. After CMP a hard mask layer 7 comprising or consisting of a dielectric material (e.g. SiN or SiO₂) is deposited on top of the monocrystalline Si 6 as shown in Figure 1h. A resist layer 8 is patterned on top of the hard mask layer.

Further, a plurality of columnar floating gate structures 9 are patterned by etching the stack comprising the hard mask layer 7 and the mono-crystalline Si material 6 and stopping on the tunnel oxide as shown in Figure 1i. The patterned structure has a half pitch between 10nm and 20nm, preferably between 11 and 13nm.

As shown in Figure 1j the tunnel oxide and the underlying substrate (monocrystalline Si) is etched further to form trenches 10 with a depth of about 300 to 350nm. In a next step (Figure 1k) shallow trench isolation (STI) regions 11 are formed by filling the trenches 10 with an insulating material (preferably silicon oxide). The STI oxide fills the trenches to a height just above the tunnel oxide 2, but leaves the largest part of the floating gate structures 9 exposed.

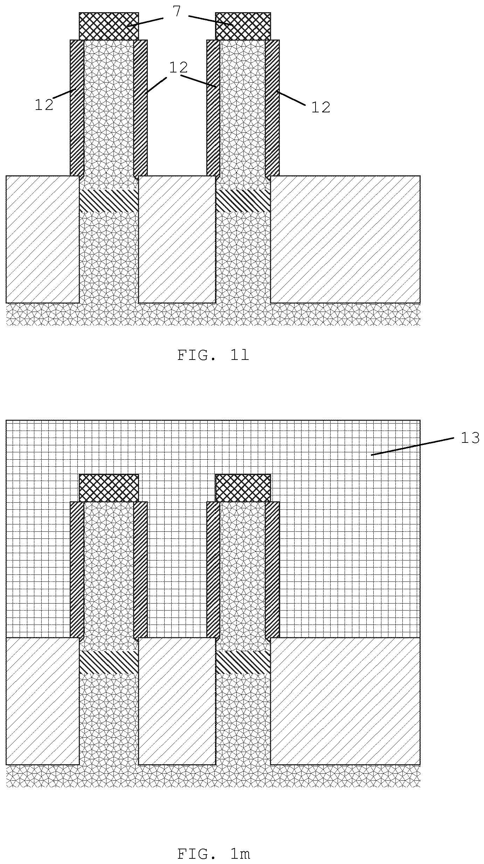

In a next step (Figure 1l) an SiO₂ layer 12 is formed on the sidewalls of the floating gate structures 9 by thermal oxidation of the monocrystalline silicon the floating gate is made of. In this way a very thin layer (between 5nm and 15nm, preferably between 5 and 10 nm, more preferably between 6 and 8nm of high quality thermal oxide is formed on the sidewalls of the floating gate structures with a half pitch of 10-20nm, preferably 10-15nm, more preferably 11-13nm. The above numbers for the half pitch are based on the floating gate structures having a length (thickness) of 5nm, and the control gate structures (fig. 1m) have also a length of 5nm.

Advantageously the hard mask layer 7 is kept on top of the floating gate structures preventing unwanted leakage between the top surface of the floating gate or the top corners of the floating gate and the control gate 13. Preferably, the hard mask layer 7 left on top of the floating gate structures acts as top inter-poly dielectric in between the mono-crystalline floating gate and the control gate. Advantageously, the thickness of the hard mask layer (7) is higher than the thickness of the thermally grown SiO₂ layers 12 (preferably about 5-15nm thicker).

Further a control gate (CG) (13) is formed by depositing (e.g. by CVD) a polysilicon material completely surrounding the floating gate structures having the thermally grown SiO₂ layers 12 formed on the sidewalls as shown in Figure 1m.

The above method steps lead to a dense pattern of columnar floating gates in mono-crystalline Si and provided with a thermal oxide on both sides. Following the method of the invention a half pitch of 11-13 nm can be achieved, due to the low thickness at which a thermally grown SiO₂ layer can be produced on the sidewalls of the floating gate structures. This half pitch would not be possible with an ONO interpoly dielectric thickness.

The method according to the invention yields the advantage that columnar floating gate structures can be produced with a half-pitch below 20nm, preferably of 11-13nm, which would not be possible with an ONO-interpoly dielectric thickness.

The resulting structure obtained by the invention is operated like a normal NAND memory array (see e.g. "Nonvolatile memory technologies with emphasis on Flash", Wiley-Interscience 2007, p.227-237 ISBN 978-0471-77002-2) after patterning the control gates and the floating gates in a direction perpendicular to the direction of the STI regions. Every floating gate is at the intersection of a region of the substrate where STI regions 11 are not formed, which acts as the NAND string, and of a control gate, which acts as the wordline of the memory array.

## Claims

1. A method for producing a floating gate memory device comprising the steps of :
• Providing a monocrystalline semiconductor substrate (1),
• Forming a tunnel oxide layer (2) on said substrate,
• Producing one or more openings in said tunnel oxide, to expose areas (5) of said semiconductor substrate,
• Cleaning the exposed substrate with a cleaning liquid,
• Loading the substrate into an epitaxial reactor, and thereafter :
• Optionally, annealing the substrate, to thereby remove any remaining oxides from the areas (5),
• Epitaxially growing a monocrystalline semiconductor layer (6) on the substrate by selective epitaxial growth using the exposed substrate areas (5) as source areas,
• Planarizing the monocrystalline semiconductor layer (6),
• Depositing a hard mask layer (7) made of dielectric material on the planarized monocrystalline layer (6),
• Depositing and patterning a layer of resist (8) on the hard mask layer (7),
• Etching the monocrystalline layer (6), stopping on the tunnel oxide layer (2), thereby forming columnar monocrystalline floating gate structures (9),
• Etching trenches (10) between said columnar floating gate structures (9), through the portions of the tunnel oxide layer (2) situated between the columnar floating gate structures (9),
• Filling said trenches with a dielectric material (11), leaving a portion of the columnar floating gate structures (9) exposed,
• Thermally growing an oxide layer (12) on each of the lateral sides of the columnar floating gate structures (9),
• Depositing a control gate layer (13) between and on top of said columnar floating gate structures (9), so that the control gate layer is directly on the totality of the thermally grown oxide layer on the lateral sides of the columnar floating gate structures.

2. Method according to claim 1, further comprising, after the step of forming a tunnel oxide layer (2), the step of depositing a protective layer (3) on said tunnel oxide layer, thereby forming a stack of the tunnel oxide (2) and the protective layer (3) on the substrate (1), and wherein said openings are produced in said stack, to expose said areas (5) of the semiconductor substrate, and further comprising the step, after the steps of loading the substrate into an epitaxial reactor and optionally annealing the substrate and before the step of epitaxially growing a monocrystalline semiconductor layer, of removing the protective layer (3), by an in-situ etching process wherein the protective layer (3) is etched selectively with respect to the tunnel oxide layer (2).

3. Method according to claim 2, wherein the selectivity of the etching process for etching the protective layer (3) versus etching the tunnel oxide layer (2) is 100:1 or more.

4. Method according to claim 2 or 3, wherein said substrate is a monocrystalline Si substrate (1), and wherein said tunnel oxide layer (2) is a thermally grown layer of SiO₂ and said protective layer is an amorphous Si layer or a polycrystalline Si layer.

5. Method according to claim 4, wherein said cleaning liquid is hydrogen fluoride (HF), and wherein said in-situ etching process is performed by exposing the substrate to a halogen containing precursor.

6. Method according to any one of claims 1 to 5, wherein the thickness of said thermally grown oxide layer (12) on the lateral sides of said floating gate structures (9) is between 5nm and 15nm, preferably between 5nm and 10nm, more preferably between 6nm and 8nm.

7. Method according to claim 6, wherein the half pitch between adjacent columnar floating gate structures is between 10nm and 20nm, preferably between 10nm and 15nm, more preferably between 11nm and 13nm.

8. A floating gate memory device, comprising at least one array of columnar floating gate structures (9) of monocrystalline semiconductor material, with control gate structures (13) in between said columnar structures,wherein each of said columnar structures (9) is provided with an oxide layer (12) on each lateral side plane of said columnar structures, to thereby isolate each floating gate structure (9) from the neighbouring control gate structures (13),
**characterized in that** :
• the oxide layers (12) cover substantially the complete surface of said side planes of the columnar structures,
• the control gate structures (13) are directly on the totality of said oxide layers (12), and
• the thickness of said oxide layers (12) is between 5nm and 15nm, preferably between 5nm and 10nm, more preferably between 6nm and 8nm and the half pitch of said array is between 10nm and 20nm, preferably between 10nm and 15nm, more preferably between 11nm and 13 nm, and
• a hard mask dielectric layer portion (7) is on top of said columnar floating gate structures (9).

9. Device according to claim 8, wherein said oxide layer (12) on each lateral side plane is a thermally grown oxide layer.

10. Device according to claims 8 or 9, wherein the thickness of said hard mask dielectric layer portion (7) is higher than the thickness of said oxide layers (12) on the lateral side planes of said columnar floating gate structures (9).

11. Device according to any one of claims 8 to 10, wherein said control gate structures (13) are completely surrounding said columnar floating gate structures (9).

12. Device according to claim 11, wherein said control gate structures (13) are polysilicon structures.

13. Device according to any one of claims 8 to 12, wherein said columnar floating gate structures (9) comprise a tunnel oxide layer (2) of thermally grown oxide.

14. Device according to claim 13, wherein the thickness of said thermally grown tunnel oxide layer (2) is between 5 and 10nm.

## Patentansprüche

1. Verfahren zum Herstellen einer Floating-Gate-Speichereinheit, das die Schritte umfasst:
• Bereitstellen eines monokristallinen Halbleitersubstrats (1),
• Bilden einer Tunneloxidschicht (2) auf dem Substrat,
• Bilden einer oder mehrerer Öffnungen in dem Tunneloxid, um Bereiche (5) des Halbleitersubstrats freizulegen,
• Reinigen des freigelegten Substrats mit einer Reinigungsflüssigkeit,
• Laden des Substrats in einen Epitaxiereaktor, und danach :
• Optionales, Tempern des Substrats, um damit sämtliche Restoxide aus den Bereichen (5) zu entfernen,
• epitaktisches Wachsen einer monokristallinen Halbleiterschicht (6) auf dem Substrat durch selektives epitaktisches Wachstum unter Verwendung der freigelegten Substratbereiche (5) als Source-Bereiche,
• Planarisieren der monokristallinen Halbleiterschicht (6),
• Abscheiden einer Hartmaskenschicht (7), die aus dielektrischem Material hergestellt ist, auf der planarisierten monokristallinen Schicht (6),
• Abscheiden und Mustern einer Resistschicht (8) auf der Hartmaskenschicht (7),
• Ätzen der monokristallinen Schicht (6), wobei auf der Tunneloxidschicht (2) gestoppt wird, um säulenartige monokristalline Floating-Gate-Strukturen (9) zu bilden,
• Ätzen von Schlitzen (10) zwischen den säulenartigen Floating-Gate-Strukturen (9), durch die Abschnitte der Tunneloxidschicht (2), die sich zwischen den säulenartigen Floating-Gate-Strukturen (9) befinden,
• Füllen der Schlitze mit einem dielektrischen Material (11), wobei ein Abschnitt der säulenartigen Floating-Gate-Strukturen (9) freigelegt bleibt,
• thermisches Wachsen einer Oxidschicht (12) auf jeder der lateralen Seiten der säulenartigen Floating-Gate-Strukturen (9),
• Abscheiden einer Control-Gate-Schicht (13) zwischen und oben auf den säulenartigen Floating-Gate-Strukturen (9), so dass sich die Control-Gate-Schicht direkt auf der gesamten thermisch gewachsenen Oxidschicht auf den lateralen Seiten der säulenartigen Floating-Gate-Strukturen befindet.

2. Verfahren nach Anspruch 1, das des Weiteren nach dem Schritt des Bildens einer Tunneloxidschicht (2) den Schritt des Abscheidens einer Schutzschicht (3) auf der Tunneloxidschicht umfasst, um einen Stapel des Tunneloxids (2) und der Schutzschicht (3) auf dem Substrat (1) zu bilden, und wobei die Öffnungen in dem Stapel gebildet werden, um die Bereiche (5) des Halbleitersubstrats freizulegen, und das des Weiteren nach den Schritten des Ladens des Substrats in einen Epitaxiereaktor und des optionalen Temperns des Substrats und vor dem Schritt des epitaktischen Wachsens einer monokristallinen Halbleiterschicht, den Schritt des Entfernens der Schutzschicht (3) durch einen In-situ-Ätzprozess umfasst, wobei die Schutzschicht (3) in Bezug auf die Tunneloxidschicht (2) selektiv geätzt wird.

3. Verfahren nach Anspruch 2, wobei die Selektivität des Ätzprozesses zum Ätzen der Schutzschicht (3) versus Ätzen der Tunneloxidschicht (2) 100:1 oder mehr ist.

4. Verfahren nach Anspruch 2 oder 3, wobei das Substrat ein monokristallines Si-Substrat (1) ist, und wobei die Tunneloxidschicht (2) eine thermisch gewachsene SiO₂-Schicht ist und die Schutzschicht eine amorphe Si-Schicht oder eine polykristalline Si-Schicht ist.

5. Verfahren nach Anspruch 4, wobei die Reinigungsflüssigkeit Wasserstofffluorid (HF) ist, und wobei der In-situ-Ätzprozess durch Freilegen des Substrats gegenüber einem halogenhaltigen Vorläufer durchgeführt wird.

6. Verfahren nach einem der Ansprüche 1 bis 5, wobei die Dicke der thermisch gewachsenen Oxidschicht (12) auf den lateralen Seiten der Floating-Gate-Strukturen (9) zwischen 5 nm und 15 nm, vorzugsweise zwischen 5 nm und 10 nm, mehr bevorzugt zwischen 6 nm und 8 nm, beträgt.

7. Verfahren nach Anspruch 6, wobei der Half-Pitch zwischen benachbarten säulenartigen Floating-Gate-Strukturen zwischen 10 nm und 20 nm, vorzugsweise zwischen 10 nm und 15 nm, mehr bevorzugt zwischen 11 nm und 13 nm, beträgt.

8. Floating-Gate-Speichereinheit, die zumindest eine Anordnung von säulenartigen Floating-Gate-Strukturen (9) aus monokristallinem Halbleitermaterial umfasst, wobei Control-Gate-Strukturen (13) zwischen den säulenartigen Strukturen vorgesehen sind, wobei jede der säulenartigen Strukturen (9) mit einer Oxidschicht (12) auf jeder lateralen Seitenebene der säulenartigen Strukturen versehen ist, um jede Floating-Gate-Struktur (9) gegenüber den benachbarten Control-Gate-Strukturen (13) zu isolieren,
**dadurch gekennzeichnet, dass**:
• die Oxidschichten (12) im Wesentlichen die gesamte Oberfläche der Seitenebenen der säulenartigen Strukturen bedecken,
• die Control-Gate-Strukturen (13) sich direkt auf den gesamten Oxidschichten (12) befinden, und
• die Dicke der Oxidschichten (12) zwischen 5 nm und 15 nm, vorzugsweise zwischen 5 nm und 10 nm, mehr bevorzugt zwischen 6 nm und 8 nm, beträgt und der Half-Pitch der Anordnung zwischen 10 nm und 20 nm, vorzugsweise zwischen 10 nm und 15 nm, mehr bevorzugt zwischen 11 nm und 13 nm, beträgt, und
• ein Hartmasken-Dielektrische-Schicht-Abschnitt (7) sich oben auf den säulenartigen Floating-Gate-Strukturen (9) befindet.

9. Einheit nach Anspruch 8, wobei die Oxidschicht (12) auf jeder lateralen Seitenebene eine thermisch gewachsene Oxidschicht ist.

10. Einheit nach Anspruch 8 oder 9, wobei die Dicke des Hartmasken-Dielektrische-Schicht-Abschnitts (7) größer als die Dicke der Oxidschichten (12) auf den lateralen Seitenebenen der säulenartigen Floating-Gate-Strukturen (9) ist.

11. Einheit nach einem der Ansprüche 8 bis 10, wobei die Control-Gate-Strukturen (13) die säulenartigen Floating-Gate-Strukturen (9) vollständig umgeben.

12. Einheit nach Anspruch 11, wobei die Control-Gate-Strukturen (13) Polysiliciumstrukturen sind.

13. Einheit nach einem der Ansprüche 8 bis 12, wobei die säulenartigen Floating-Gate-Strukturen (9) eine Tunneloxidschicht (2) aus thermisch gewachsenem Oxid umfassen.

14. Einheit nach Anspruch 13, wobei die Dicke der thermisch gezüchteten Tunneloxidschicht (2) zwischen 5 und 10 nm beträgt.

## Revendications

1. Procédé de fabrication d'un dispositif de mémoire à grille flottante comprenant les étapes suivantes :
- la fourniture d'un substrat semi-conducteur monocristallin (1),
- la formation d'une couche d'oxyde à effet tunnel (2) sur ledit substrat,
- la production d'une ou plusieurs ouvertures dans ledit oxyde à effet tunnel, pour exposer les zones (5) dudit substrat semi-conducteur,
- le nettoyage du substrat exposé à l'aide d'un liquide de nettoyage,
- le chargement du substrat dans un réacteur épitaxial, et par la suite :
- éventuellement, le recuit du substrat, afin d'éliminer tous les oxydes résiduels des zones (5),
- la croissance épitaxiale d'une couche semi-conductrice monocristalline (6) sur le substrat par croissance épitaxiale sélective en utilisant les zones du substrat exposées (5) en tant que zones sources,
- la planarisation de la couche semi-conductrice monocristalline (6),
- le dépôt d'une couche de masquage dure (7) composée de matériau diélectrique sur la couche monocristalline planarisée (6),
- le dépôt et la structuration d'une couche de résist (8) sur la couche de masquage dure (7),
- la gravure de la couche monocristalline (6), s'arrêtant sur la couche d'oxyde à effet tunnel (2), formant ainsi des structures à grille flottante monocristallines colonnaires (9),
- la gravure de rainures (10) entre lesdites structures à grille flottante colonnaires (9), à travers les parties de la couche d'oxyde à effet tunnel (2) situées entre les structures à grille flottante colonnaires (9),
- le remplissage desdites rainures avec un matériau diélectrique (11), en laissant une partie des structures à grille flottante colonnaires (9) exposées,
- la croissance thermique d'une couche d'oxyde (12) sur chacune des faces latérales des structures à grille flottante colonnaires (9),
- le dépôt d'une couche de grille de commande (13) entre lesdites structures à grille flottante colonnaires (9) et au-dessus d'elles, de telle sorte que la couche de grille de commande se trouve directement sur la totalité de la couche d'oxyde formée par croissance thermique sur les faces latérales des structures à grille flottante colonnaires.

2. Procédé selon la revendication 1, comprenant en outre, après l'étape de formation d'une couche d'oxyde à effet tunnel (2), l'étape de dépôt d'une couche de protection (3) sur ladite couche d'oxyde à effet tunnel, formant ainsi un empilement de l'oxyde à effet tunnel (2) et de la couche de protection (3) sur le substrat (1), et dans lequel lesdites ouvertures sont produites dans ledit empilement pour exposer lesdites zones (5) du substrat semi-conducteur, et comprenant en outre l'étape, après les étapes de chargement du substrat dans un réacteur épitaxial et éventuellement de recuit du substrat et avant l'étape de croissance épitaxiale d'une couche semi-conductrice monocristalline, d'enlèvement de la couche de protection (3), à l'aide d'un processus de gravure in situ dans lequel la couche de protection (3) est gravée sélectivement par rapport à la couche d'oxyde à effet tunnel (2).

3. Procédé selon la revendication 2, dans lequel la sélectivité du processus de gravure pour graver la couche de protection (3) par rapport à la gravure de la couche d'oxyde à effet tunnel (2) est supérieure ou égale à 100:1.

4. Procédé selon la revendication 2 ou 3, dans lequel ledit substrat est un substrat de Si monocristallin (1), et dans lequel ladite couche d'oxyde à effet tunnel (2) est une couche formée par croissance thermique de SiO₂ et ladite couche de protection est une couche de Si amorphe ou une couche de Si polycristallin.

5. Procédé selon la revendication 4, dans lequel ledit liquide de nettoyage est du fluorure d'hydrogène (HF), et dans lequel ledit processus de gravure in situ est réalisé par exposition du substrat à un précurseur contenant un halogène.

6. Procédé selon l'une quelconque des revendications 1 à 5, dans lequel l'épaisseur de ladite couche d'oxyde formée par croissance thermique (12) sur les faces latérales desdites structures à grille flottante (9) est comprise entre 5 nm et 15 nm, de préférence, entre 5 nm et 10 nm, de manière davantage préférée, entre 6 nm et 8 nm.

7. Procédé selon la revendication 6, dans lequel le demi-intevalle entre les structures à grille flottante colonnaires adjacentes est compris entre 10 nm et 20 nm, de préférence, entre 10 nm et 15 nm, de manière davantage préférée, entre 11 nm et 13 nm.

8. Dispositif de mémoire à grille flottante, comprenant au moins un réseau de structures à grille flottante colonnaires (9) de matériau semi-conducteur monocristallin, avec des structures de grille de commande (13) entre lesdites structures colonnaires, dans lequel chacune desdites structures colonnaires (9) est dotée d'une couche d'oxyde (12) sur chaque plan de face latérale desdites structures colonnaires, afin d'isoler de la sorte chaque structure à grille flottante (9) des structures de grille de commande (13) voisines,
**caractérisé en ce que** :
- les couches d'oxyde (12) couvrent essentiellement la surface complète desdits plans latéraux des structures colonnaires,
- les structures de grille de commande (13) se trouvent directement sur la totalité desdites couches d'oxyde (12), et
- l'épaisseur desdites couches d'oxyde (12) est comprise entre 5 nm et 15 nm, de préférence, entre 5 nm et 10 nm, de manière davantage préférée entre 6 nm et 8 nm et le demi-intervalle dudit réseau est compris entre 10 nm et 20 nm, de préférence entre 10 nm et 15 nm, de manière davantage préférée entre 11 nm et 13 nm, et
- une partie de couche diélectrique de masquage dure (7) se trouve au-dessus desdites structures à grille flottante colonnaires (9).

9. Dispositif selon la revendication 8, dans lequel ladite couche d'oxyde (12) sur chaque plan de face latérale est une couche d'oxyde formée par croissance thermique.

10. Dispositif selon les revendications 8 ou 9, dans lequel l'épaisseur de ladite partie de couche diélectrique de masquage dure (7) est supérieure à l'épaisseur desdites couches d'oxyde (12) sur les plans de faces latérales desdites structures à grille flottante colonnaires (9).

11. Dispositif selon l'une quelconque des revendications 8 à 10, dans lequel lesdites structures de grille de commande (13) entourent complètement lesdites structures à grille flottante colonnaires (9).

12. Dispositif selon la revendication 11, dans lequel lesdites structures de grille de commande (13) sont des structures en polysilicium.

13. Dispositif selon l'une quelconque des revendications 8 à 12, dans lequel lesdites structures à grille flottante colonnaires (9) comprennent une couche d'oxyde à effet tunnel (2) constituée d'oxyde formé par croissance thermique.

14. Dispositif selon la revendication 13, dans lequel l'épaisseur de ladite couche d'oxyde à effet tunnel formée par croissance thermique (2) est comprise entre 5 et 10 nm.
